## Europäisches Patentamt

## European Patent Office

## Office européen des brevets

(11) Publication number: **0 374 996**
**A1**

## (12) EUROPEAN PATENT APPLICATION

(21) Application number: **89203009.9**

(22) Date of filing: **27.11.89**

(51) Int. Cl.⁵: **H03D 1/22, H04H 1/00**

(30) Priority: **01.12.88 NL 8802961**

(43) Date of publication of application:
**27.06.90 Bulletin 90/26**

(84) Designated Contracting States:
**AT CH DE ES FR GB IT LI SE**

(71) Applicant: **N.V. Philips' Gloeilampenfabrieken**
**Groenewoudseweg 1**
**NL-5621 BA Eindhoven(NL)**

(72) Inventor: **Kamalski, Theodor Ignatius Eduard**
**c/o INT. OCTROOIBUREAU B.V. Prof.**
**Holstlaan 6**
**NL-5656 AA Eindhoven(NL)**

(74) Representative: **Schoonheijm, Harry Barend et**
**al**
**INTERNATIONAAL OCTROOIBUREAU B.V.**
**Prof.Holstlaan 6**
**NL-5656 AA Eindhoven(NL)**

(54) **FM-receiver.**

(57) FM-receiver including a FM-detector (FD) coupled to a demodulator (DD) for demodulating a biphase encoded digital radio data signal which is double-sideband amplitude-modulated on a suppressed sub-carrier, the demodulator comprising first and second phase detectors (1, 2) to which the data radio signal to be demodulated is applied and also, from a controllable oscillator (7), an in-phase and quadrature oscillator signal, respectively, which for a selection of the radio data signal are coupled via respective first and second filter members (3, 4) to a multiplier circuit (5), the multiplier circuit being coupled to a control input of the controllable oscillator via a loop filter (6), the first filter member also being coupled to an output of the demodulator. So as to enable a rapid recognition of the reception of a RDS-signal a band-elimination filter (N) is arranged between the FM-detector and the demodulator having a resonant frequency which is predominantly located at the frequency of the sub-carrier and a band-elimination range which is predominantly located between the frequency bands of the modulated radio data signal, and the signal path between the second filter member and the controllable oscillator is coupled to an input of a processing circuit (M) for processing a data indication.

## FM-receiver

The invention relates to an FM-receiver, including an FM-detector coupled to a demodulator for demodulating a bi-phase encoded digital radio signal which is double-sideband amplitude-mdoulated on a suppressed sub-carrier, the demodulator comprising first and second phase detectors, to which the radio data signal to be demodulated is applied and also, from a controllable oscillator, an in-phase and quadrature oscillator signal, respectively, which, for a selection of the radio data signal, are coupled via respective first and second filter members to a multiplier circuit, the multiplier circuit being coupled to a control input of the controllable oscillator via a loop filter, the first filter member also being coupled to an output of the demodulator.

Such an FM-receiver is described in the article "Automatic tuning car radio on the radio data system", by K. Taura e.a., published in IEEE Transactions on Consumer Electronics, vol. CE-33, no. 3, August 1987, pp. 319-325.

The prior-art FM-receiver is suitable for the reception and processing of digital signals in a radio data system - denoted RDS-signals for short hereinafter -, as is specified in greater detail in, for example, "Specifications of the radio data system RDS for VHF/FM sound broadcasting", Tech. 2344-E, published by "European Broadcasting Union" in March, 1984. The RDS-signal comprises digital tuning and program information which can inter alia be used to increase the ease of operation. This digital RDS-information is transmitted on a 57 KHz sub-carrier in the base band of an FM-broadcasting signal. In this situation the 57 KHz sub-carrier is double-sideband amplitude-modulated by the bi-phase encoded data signal with suppressed carrier (DSB-SC). This modulation mode can alternatively be considered as a bi-phase PSK modulation with a phase deviation of + or -90°.

In the prior-art FM-receiver a demodulation of the RDS-signal modulated on the 57 KHz sub-carrier is effected by means of the said demodulator arranged at the output of the FM-detector. This demodulator is of a digital implementation and of the Costas loop type, the first phase detector of which synchronously demodulates the sub-carrier-modulated RDS-signal with the aid of the in-phase oscillator signal. For a correct synchronous demodulation of the RDS-signal the in-phase oscillator signal must be accurately in phase or in anti-phase with the suppressed 57 KHz sub-carrier. To that end a phase control signal for the oscillator is derived from the mixed product of the RDS-signal demodulated in the first detector and the version, obtained in the second phase detector and shifted

through 90°, of this demodulated RDS-signal or a low-frequency portion thereof.

In the present introduction phase of the RDS-system there are, in addition to the RDS-transmitters which exclusively use the suppressed 57 KHz sub-carrier for the transmission of RDS-information, transmitters, for example traffic transmitters in the socalled ARI-system, which utilizes the 57 KHz sub-carrier for the transmission of analog traffic identification signals, as welled transmitters transmitting on the 57 KHz sub-carrier both RDS and the said traffic transmitter identification signals. In addition, because of multi-path reception in the receiver, a 57 KHz noise frequency may be caused by a 19 KHz stereo pilot.

In the prior-art FM-receiver identification of RDS-transmitters is enabled by, for example, decoding the RDS-signal after demodulation and by detecting a bit level whether code words included in the RDS-specification are present. This mode of RDS-transmitter recognition requires however comparatively much time. A faster recognition of the reception of a RDS-signal may be desired in certain circumstances, for example for receivers in which a storage of alternative frequencies is effected to enable a reliable detection of the presence of a RDS-signal during an inaudible brief switching of the tuning to each one of these alternative frequencies.

The invention has for its object to provide a fast recognition of RDS-transmitters, and an FM-receiver of the type defined in the opening paragraph, is characterized according to the invention in that a band-elimination filter is arranged between the FM-detector and the demodulator having a resonant frequency which is predominantly located at the sub-carrier frequency, and a band-elimination range which is predominantly located between the frequency bands of the modulated radio data signal, the signal path between the second filter member and the controllable oscillator being coupled to an input of a processing circuit for processing a data indication.

The invention is based on the recognition that the use of a loop demodulator for the demodulation of RDS-signals provides the possibility to immediately recognize reception of an RDS-transmitter from the fact that the phase-coupled state of the loop is obtained. Compared to a recognition of the decoded RDS-data signal, the period of reception of a RDS-signal and recognition thereof is shortened by a period of time of at least the duration in which an adequate decoding is effected.

When the measure according to the invention is used, the fact that the phase-coupled state of the digital demodulator has been obtained is derived from the amplitude of the signal in the phase control loop between the second filter member and the controllable oscillator and is displayed in an RDS indication signal. By means of the band-elimination filter false phase couplings, that is to say phase couplings on a transmitted sub-carrier or a 57 KHz sub-carrier without RDS-modulation caused by multi-path reception are prevented from occuring. The processing of the RDS indication signal in the said processing circuit may result in, for example, an optical display of RDS-signal reception, which in a memory for the storage of what are commonly denoted alternative frequencies is attached to the relevant transmitter frequency, and/or result in a search tuning operation in a rapid selection of RDS-transmitters.

A preferred embodiment of an FM-receiver in accordance with the invention, is characterized in that the said processing circuit includes an arrangement for the storage of alternative frequencies and for adding a radio data signal presence indication to the alternative frequency the FM-receiver is tuned to at that moment.

When this measure is used, the alternative frequency storage feature provided by the RDS-system, that is to say transmitters transmitting the same program as, or a program which can be considered to be an alternative for, the program of the tuner in which the transmitter is tuned to at that instant, is enlarged with the feature of indicating at each alternative frequency whether the relevant transmitter transmits RDS-signals or does not transmit RDS-signals. Thus an unwanted switch of the tuning to a non-RDS transmitter can be prevented.

A preferred embodiment of an FM-receiver according to the invention, is characterized in that a limiter is arranged between the band elimination filter and the said demodulator for limiting the modulated radio data signal and the loop filter includes a digital counter, whose counting position varies in a direction which depends on the sign of the phase difference between the in-phase oscillator frequency and the sign of the suppressed sub-carrier and has a fixed value when the phases between the said two frequencies are in synchronism, the counter being coupled to the input of the said processing circuit.

The use of a limiter before the demodulator enables a digital signal processing in the demodulator, so that the demodulator in its totality is integrable and, in addition, a digital counter can be used as the integrating loop filter, which by means of a given counting position indicates that the phase-coupled state of the demodulator has been obtained, which counting position can at the same time be used as a RDS indication signal.

A further preferred embodiment is characterized in that the band-elimination filter is of the time discrete filter type and has the advantage that unwanted frequencies, which may result in false phase couplings, are suppressed very accurately and effectively.

Preferably, the said first and second filter members are realised by means of integrating digital counting circuits and have a low-pass range of at least 2400 Hz.

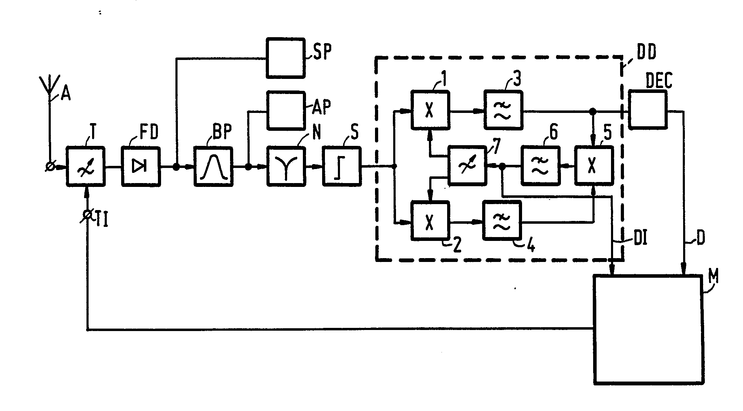

The invention and its advantages will now be described in greater detail by way of example with reference to the concise circuit diagram of an FM-receiver according to the invention, shown in the sole Figure which only serves by way of illustration.

The FM-receiver shown has an aerial input I for connection to an aerial A, to which there are coupled, in this sequence, a FM HF/FM-receiver section T, an FM-detector FD, a bandpass filter BP, a band-elimination or notch filter M, a slicer S, a digital RDS-demodulator DD, an RDS-decoder DEC and an RDS-data processing circuit M. The FM HF/FM-receiver section T processes, converts and selects in a manner known per se a desired AF/FM receiving signal in an IF/FM signal and is inter alia provided with a tuning circuit, not shown, which is controllable by means of a tuning voltage applied to a tuning input TI. The IF-FM signal supplied by T is demodulated in the frequency detector FD which results in a baseband modulation signal which may include data information in addition to audio information. The audio information is thereafter aplied to a sound signal processing circuit SP, in which a further processing into stereo sound signals and display of the audio information is optionally effected.

On reception of a digital radio data signal - abbreviated to RDS-signal hereinafter - in accordance with the said EB4-specification Tech. 3244-E B the baseband modulation signal at the output of FD contains a suppressed 57 KHz sub-carrier which is double-sideband amplitude-modulated with the differential, bi-phase encoded RDS-signal. The frequency spectrum of the RDS-signal modulated on the 57 KHz sub-carrier is predominantly located in two-side-bands which are situated symmetrically around the suppressed 57 KHz sub-carrier frequency. The 57 KHz sub-carrier can however alternative be used for the transmission of what is commonly denoted the ARI-signal, which is used to identify a traffic transmitter. On transmission of a ARI-signal, this signal modulates the amplitude of the 57 KHz sub-carrier, which results in a plurality of frequency components, which occurs symmetrically around the 57 KHz sub-carrier, which now is not suppressed, between the two-side-bands of the RDS-signal. If simultaneously with the RDS-signal, an ARI-signal is transmitted, both signals are selected from the baseband modulation signal at the output of the frequency demodulator FD by means of a bandpass filter BP. A further processing and, optionally, display of the ARI-signal is effected in an ARI processing circuit AP which is coupled to the bandpass filter BP and is known per se from, for example, said article by K. Taura.

Frequency components between the two sidebands are removed by means of a narrowband band-elimination or notch filter N, which is predominantly tuned to the 57 KHz sub-carrier frequency from the modulated RDS-signal selected by the bandpass filter BP. This notch filter N does not only suppress the ARI-signal but in the case of stereo signal reception also by noise signals, caused by multi-path reception and/or non-linearities from the 19 KHz stereo pilot, at this frequency. It has been found that the band-elimination filter N at the same time reduces the sensitivity of the RDS-signal to multi-path reception to a very large extent. The RDS frequency sidebands thus selected are thereafter applied to an input of the digital demodulator DD via a slicer S for limiting the modulated RDS-signal. So as to enable a comparatively large increase in the edge steepness of the modulated RDS-signal a bistable multi-vibrator is used as the slicer S.

The digital demodulator DD is predominantly comprised of what is commonly denoted a Costas loop 1-7, comprising first and second phase detectors 1 and 2 having signal inputs coupled to the output of the slicer S, mixed signal inputs coupled to the respective in-phase and quadrature outputs of a controllable oscillator 7, and having outputs which are coupled to inputs of a multiplier circuit 5 via respective first and second filter members 3 and 4. An output of the multiplying circuit 5 is coupled to a control input of the controllable oscillator 7 via a loop filter 6. The first phase detector 1 also functions as a synchronous demodulator and produces the demodulated, baseband RDS-signal, which after selection in the first filter member 3 is aplied to the decoder arrangement DEC.

In the decoder arrangement DEC decoding of the RDS-signal is effected, followed by a processing of RDS-data in the RDS-data processing circuit M. The RDS-data processing circuit M includes a memory circuit for the storage of what are commonly denoted alternative frequencies, each indicating a transmitter transmitting a program which corresponds to or is an alternative of the program of the transmitter tuned to at that moment. The circuit M also includes means for applying a tuning control signal to the tuning input TI of the FM HF/MF receiving section T, which sequentially repeating effects a brief tuning to each of the said alternative frequencies or a continuous monitoring of the receiving quality of the alternative transmitters. In the memory circuit of M the information about the quality of the reception is attached to the relevant alternative frequency and is continuously refreshed.

Because of the limitation in S, a digital signal processing is possible in the RDS-demodulator DD of the FM-receiver shown. As a result thereof, the multiplier circuits 1, 2 and 5 can be implemented by means of exclusive OR-gates and the first and second filter members 3 and 4 can be realised by means of integrating counter circuits (integrate and dump), whereas the loop filter 6 can be realised in known manner by means of one or a plurality of cascade-arranged integrating binary up/down counters, for example with the aid of integrated circuits of the type HEF 4029.

The demodulation, decoding and processing of the RDS-signal, described so far, in the RDS-demodulator DD, the RDS-decoder DEC and RDS-data processing circuit M, respectively, are known per se from the said article by K. Taura and do not need a further detailed description for an understanding of the invention.

In the phase-coupled state of the digital demodulator DD the in-phase and quadrature oscillator signal, respectively, of the controllable oscillator 7 is in-phase or in anti-phase and in phase quadrature, respectively, with the suppressed 57 KHz sub-carrier of the modulated RDS-sginal and the loop filter 6 applies a given binary value as a phase control signal to the controllable oscillator 7, for example the value 0. A detection of the output value of the loop filter 6 is effected in the RDS-data processing circuit 11. To that end the loop filter 6 is connected via a connecting line DI to a comparison circuit, not shown, which is included in M and compares the said output value with the binary value fixedly stored in M and at the occurrence of this binary value generates an RDS-indication signal at the output of the loop filter 6. Thus, recognizing the reception of a RDS-sginal is possible within a period of time predominantly corresponding to the pull-in period of the Costas loop which functions as the RDS-demodulator DD, which period of time is significantly shorter than the time necessary for recognition of the RDS-signal at bit level, that is to say after decoding. In a practical embodiment the maximum pull-in time, that is to say the time necessary to control a maximum phase error of 90° to zero or substantially zero, amounts to 1 msec. This RDS-indication signal can be used directly for an optical displayed indication that the transmitter is indeed at that moment tuned to a RDS-transmitter, or if an alternative frequency was briefly tuned to, can be stored in the memory of the circuit M as the RDS-indication at this alternative frequency. When a deterioration of the receiving quality of the transmitter to which tuning has been effected gives rise to a switch to an alternative frequency having a better receiving quality, a switch to a non-RDS-transmitter can be effected, if desired.

Incorrect phase couplings of the digital demodulator, that is to say phase couplings to a received 57 KHz sub-carrier frequency or to a 57 KHz noise frequency may result in an incorrect RDS-indication, which is prevented by the band-elimination filter N. In order to enable an accurate tuning of this band-elimination filter N to the 57 KHz sub-carrier frequency in a simple manner, a band-elimination filter of the time-discrete type, for example of the switched capacitance type, can be used for that purpose, to which a clock signal is applied from a fixed oscillator (not shown).

It will be obvious that the invention is not limited to the embodiment shown. Thus, it is very well possible, without departing from the scope of the inventive idea, to perform the action of the integrating digital up/down counters of the loop filter 6 in the integrating counting circuits of the first and second counting members 3 and 4, to use an analog Costas loop as the demodulator for the RDS-signal and to indicate an RDS-reception when the output signal of the loop filter 6 is predominantly zero, instead of using analog bandpass filters or low-pass filters for the filter members 3 and 4, in which analog low-pass or bandpass filters are used for the filter members 3 and 4 instead of digital filters, and/or use the RDS-presence indication for a purpose different from the purpose described in the example.

## Claims

1. An FM-receiver, including an FM-detector coupled to a demodulator for demodulating a bi-phase encoded digital radio data signal which is double-sideband amplitude-modulated on a suppressed sub-carrier, the demodulator comprising first and second phase detectors, to which the data radio signal to be demodulated is applied and also, from a controllable oscillator, an in-phase and quadrature oscillator signal, respectively, which for a selection of the radio data signal are coupled via respective first and second filter members to a multiplier circuit, the multiplier circuit being coupled to a control input of the controllable oscillator via a loop filter, the first filter member also being coupled to an output of the demodulator, characterized in that a band-elimination filter is arranged between the FM-detector and the demodulator having a resonant frequency which is predominantly located at the sub-carrier frequency, a band-elimination range which is predominantly located between the frequency bands of the modulated radio data signal and the signal path between the second filter member and the controllable oscillator is coupled to an input of a processing circuit for processing a data indication.

2. An FM-receiver as claimed in Claim 1, characterized in that a limiter is arranged between the band-elimination filter and the said demodulator for limiting the modulated radio data signal and the loop filter includes a digital counter, whose counting position varies in a direction which depends on the sign of the phase difference between the in-phase oscillator frequency and the frequency of the suppressed sub-carrier and when there is phase synchronism between the said two frequencies has a fixed value, the counter being coupled to the input of the said processing circuit.

3. An FM-receiver as claimed in Claim 1 or 2, characterized in that the said processing circuit includes an arrangement for storing alternative frequencies and adds a radio data signal presence indication to the alternative frequency the FM-receiver is tuned to at that moment.

4. An FM-receiver as claimed in any one of the preceding Claims, characterized in that the band-elimination filter is of the time-discrete filter type.

5. An FM-receiver as claimed in any one of the preceding Claims, characterized in that the said first and second filter members are identical and each one includes an integrating counting circuit and realise a low-pass range of at least 2400 Hz.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 256 287 (BLAUPUNKT) * Column 1, line 1 - column 4, line 12; column 6, line 5 - column 9, line 23; figures 3-5 * | 1 | H 03 D 1/22 H 04 H 1/00 |
| A | DE-A-3 733 096 (PIONEER) * Page 4, lines 7-65; figure 3 * | 1 | |
| A,D | IEEE TRANSACTIONS ON CONSUMER ELECTRONICS, vol. CE-33, no. 3, August 1987, pages 319-325, IEEE, New York, US; K. TAURA et al.: "Automatic tuning car radio based on the radio data system" * Page 321, left-hand column, line 1 - page 322, right-hand column, line 18; figures 2,3 * | 1 | |
| A | IEEE TRANSACTIONS ON CONSUMER ELECTRONICS, vol. CE-33, no. 3, August 1987, pages 383-393, IEEE, New York, US; R. OGAWA et al.: "Development of radio data system decoder IC'S * Whole document * | 1 | TECHNICAL FIELDS SEARCHED (Int. Cl.5) H 03 D H 04 H H 04 B H 03 L H 03 J |

The present search report has been drawn up for all claims

| Place of search | Date of completion of the search | Examiner |
|---|---|---|
| THE HAGUE | 09-03-1990 | DHONDT I.E.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)